# EUROPÄISCHE PATENTSCHRIFT

(11) **EP 4 056 793 B1**
(45) Veröffentlichungstag und Bekanntmachung des Hinweises auf die Patenterteilung: **12.07.2023**
(21) Anmeldenummer: 22160917.5
(22) Anmeldetag: 08.03.2022
(51) Int. Cl.: E05B 67/36, B60L 53/30, H05K 5/00

(54) **VERSORGUNGSSTATION FÜR ELEKTRISCHE FAHRZEUGE UND VERSORGUNGSFUNKTIONSGRUNDANORDNUNG HIERFÜR**
SUPPLY STATION FOR ELECTRICAL VEHICLES AND SUPPLY FUNCTION BASE ASSEMBLY FOR SAME
STATION D'APPROVISIONNEMENT POUR VÉHICULE ÉLECTRIQUE ET AGENCEMENT DE BASE À FONCTION D'APPROVISIONNEMENT ASSOCIÉ

(30) Priorität: 09.03.2021 DE 102021105676
(43) Veröffentlichungstag der Anmeldung: 14.09.2022
(73) Patentinhaber: Compleo Charging Solutions AG, 44309 Dortmund (DE)
(72) Erfinder: Kachouh, Checrallah, 44227 Dortmund (DE); Dilgert, Simon, 44227 Dortmund (DE)
(74) Vertreter: Wickord, Wiro

(56) Entgegenhaltungen:
- EP-A1- 0 536 056
- WO-A1-2019/164486
- CN-A- 108 674 245
- CN-U- 210 342 993
- DE-A1-102019 207 452
- DE-B- 1 292 033
- DE-U1- 29 513 123
- GB-A- 2 142 967
- US-A- 4 006 614
- US-A- 4 688 405
- US-A1- 2012 262 114

## Beschreibung

Die Erfindung betrifft eine Versorgungsstation zum Bereitstellen elektrischer Energie für ein elektrisch betreibbares Fahrzeug umfassend eine Versorgungsgrundvorrichtung mit einem Gehäusegrundmodul als einer ersten Gehäusekomponente eines Vorrichtungsgehäuses und mit einer Mehrzahl von daran installierten Schalt- und/oder Sicherheitskomponenten, umfassend ein Gehäuseverschlussmodul als einer zweiten Gehäusekomponente des Vorrichtungsgehäuses, wobei das Gehäuseverschlussmodul an das Gehäusegrundmodul ansetzbar ist und wobei die Schalt- und/oder Sicherheitskomponenten in einer Öffnungsstellung des Gehäuseverschlussmoduls zugänglich sind und in einer Schließstellung des Gehäuseverschlussmoduls unzugänglich in dem Vorrichtungsgehäuse angeordnet sind sowie umfassend eine dem Vorrichtungsgehäuse zugeordnete Schließeinheit mit einem betätigbaren Verriegelungselement, welches von einer Verriegelungsstellung in eine Freigabestellung und zurück verbringbar ist.

Die Erfindung betrifft weiterhin eine Versorgungsfunktionsgrundanordnung für eine solche Versorgungsstation.

Eine solche Versorgungsstation oder Versorgungsfunktionsgrundanordnung ist aus dem jeweiligen Dokument DE 102019207452 A1, US 2012/262114 A1, EP 536056 A1, CN 210342993 U, WO 2019/164486 A1 und CN 108674245 A bekannt.

Eine der Bereitstellung elektrischer Energie für ein elektrisch betreibbares Fahrzeug dienende Versorgungsstation sieht heute üblicherweise eine werkseitig fest installierte, integrierte Schließeinheit mit einem Verriegelungselement vor. Die Schließeinheit ist üblicherweise an einer Klappe oder Tür der Versorgungsstation festgelegt und lässt sich schlüsselbetätigt von einer Verriegelungsstellung in eine Freigabestellung und zurück verbringen. Das Verriegelungselement der Schließeinheit hintergreift dabei in der Verriegelungsstellung eine an der Versorgungsgrundvorrichtung beziehungsweise dem Gehäusegrundmodul gebildete Rastkante.

Ein nachträglicher Austausch einer derart fest installierten und werkseitig in die Versorgungsstation integrierten Schließeinheit ist aufwendig und infolgedessen teuer. Beim Verlust eines Schlüssels entsteht insofern ein erheblicher Mehraufwand. Gleiches gilt, wenn eine Mehrzahl von Versorgungsstationen nachträglich mit einem einheitlichen Schließsystem oder gleichartigen Schließeinheiten versehen werden sollen, welche mit einem gleichen Schlüssel betätigt werden können.

Aufgabe der vorliegenden Erfindung ist es, eine in Bezug auf die Schließfunktion beziehungsweise die Schließeinheit verbesserte Versorgungsstation anzugeben.

Zur Lösung der Aufgabe ist die Erfindung in Verbindung mit dem Oberbegriff des Patentanspruchs 1 dadurch gekennzeichnet, dass ein Schließzylinder mit einem Schließzylinderkörper und dem relativ-beweglich zu dem Schließzylinderkörper an ebendiesem gehaltenen Verriegelungselement als Schließeinheit dient, wobei der Schließzylinder als ein loses Bauteil der Versorgungsstation ausgebildet ist, welches weder mit der Versorgungsgrundvorrichtung noch mit dem Gehäuseverschlussmodul des Vorrichtungsgehäuses dauerhaft verbunden ist, und dass zur Festlegung des Gehäuseverschlussmoduls relativ zu dem Gehäusegrundmodul an dem Vorrichtungsgehäuse eine Aufnahme für den Schließzylinder vorgesehen ist, in die der Schließzylinder in der Schließstellung des Gehäuseverschlussmoduls montierbar ist derart, dass der Schließzylinder in seiner Montageposition und in der Schließstellung des Gehäuseverschlussmoduls in eine an der ersten oder der zweiten Gehäusekomponente des Vorrichtungsgehäuses gebildete Durchgangsausnehmung eingreift und in die an der jeweils anderen Gehäusekomponente der Versorgungsstation gebildete Aufnahme eingesetzt ist und so eine Verbringung des Gehäuseverschlussmoduls in die Öffnungsstellung blockiert ist und dass das Verriegelungselement des in der Aufnahme eingesetzten Schließzylinders aus der Freigabestellung in die Verriegelungsstellung verbringbar ist zur Sicherung der Schließzylinders gegen eine Entnahme desselben aus der Aufnahme.

Schließzylindereinheiten dieser Art sind an sich aus den Dokumenten DE 1292033 B bzw. US 4006614 A bekannt.

Der besondere Vorteil der Erfindung besteht darin, dass durch das Vorsehen eines losen Schließzylinders als Schließeinheit der Versorgungsstation auf die werkseitige Installation der Schließeinheit verzichtet werden kann. Diese kann kundenbeziehungsweise betreiberseitig beigestellt werden mit der Folge, dass für mehrere gegebenenfalls nicht gleichzeitig gekaufte Versorgungsstationen identische beziehungsweise gleichartige Schließzylinder verwendet werden können. Verschiedene Versorgungsstationen können dann mit nur einem einzigen Schlüssel betätigt und in der Folge einfacher gewartet oder instand gesetzt werden. Ebenso ist es möglich, eine beliebige Anzahl gleicher oder unterschiedlicher Schließzylinder mit den zugehörigen Schlüsseln zu bevorraten und einer Versorgungsstation flexibel und bedarfsgerecht einen beliebigen Schließzylinder zuzuordnen. Diese Schließzylinder können in einem Fahrzeug des Kundendienstes ohne feste vorherige Zuordnung zu einer Versorgungsstation mitgeführt und vor Ort montiert werden. Der Aufwand für die Beistellung und nachträgliche Montage des Schließzylinders ist hierdurch minimal.

Im Sinne der Erfindung ist ein Schließzylinder als ein loses Bauteil der Versorgungsstation beziehungsweise als ein fliegender Schließzylinder ausgebildet, wenn dieser allein dann fest mit den anderen Komponenten der Versorgungsstation verbunden ist, wenn der Schließzylinder in der Montageposition und das Verriegelungselement des Schließzylinders in der Verriegelungsstellung vorgesehen sind. Es ist demzufolge erfindungsgemäß darauf verzichtet, den Schließzylinderkörper über geeignete andere Befestigungsmittel als dem Verriegelungselement, beispielsweise über Schrauben oder stoffschlüssig mittels Klebstoffs, lösbar an der Versorgungsgrundvorrichtung beziehungsweise dem Gehäusegrundmodul oder dem Gehäuseverschlussmodul zu befestigen. Der Schließzylinder ist also in der Montageposition in der Aufnahme der Versorgungsstation beweglich angeordnet, solange das Verriegelungselement sich in der Freigabestellung befindet. Vorteilhaft vereinfacht sich hierdurch die Montage weiter, da auf eine separate Befestigung des Schließzylinderkörpers an der Versorgungsgrundvorrichtung beziehungsweise dem Gehäusegrundmodul oder dem Gehäuseverschlussmodul verzichtet wird.

Die Festlegung des Gehäuseverschlussmoduls relativ zu beziehungsweise an dem Gehäusegrundmodul erfolgt erfindungsgemäß durch zwei Maßnahmen. Zum einen dient der Schließzylinder und bevorzugt der Schließzylinderkörper des Schließzylinders als ein Blockademittel, welches verhindert, dass das Gehäuseverschlussmodul in die Öffnungsstellung verbracht werden kann. Zum anderen dient das Verriegelungselement des Schließzylinders als ein Sicherungselement, welches in der Verriegelungsstellung verhindert, dass der Schließzylinder aus der Aufnahme entnommen werden kann und so die Blockade aufgehoben wird.

Nach einer bevorzugten Ausführungsform der Erfindung ist der Schließzylinder als ein Halbzylinder ausgebildet. Vorteilhaft reduziert sich hierdurch die Einbautiefe des Schließzylinders, sodass die Aufnahme für den Schließzylinder klein bauen kann und die Versorgungsvorrichtung insgesamt eine kompakte Bauform aufweist. Insbesondere für wandmontierte Versorgungsstationen, sogenannte Wallboxes, ist der kompakte Aufbau ein wesentliches Entwicklungsziel und Verkaufsargument.

Handelsübliche Schließzylinder, welche auch als Profilzylinder bezeichnet werden, beziehungsweise Halbzylinder sind in Bezug auf ihre Anschluss- beziehungsweise Außengeometrie genormte Bauteile. Ihre Spezifikation ergibt sich insbesondere aus der DIN 18252 beziehungsweise der DIN EN 1303. Insofern kann ein beliebiger handelsüblicher Schließ- beziehungsweise Halbzylinder als Schließeinheit für die Versorgungsstation genutzt werden. Konstruktive Anpassungen des Gehäusegrundmoduls beziehungsweise des Gehäuseverschlussmoduls an verschiedene Schließzylinder bedarf es nicht.

Nach einer Weiterbildung der Erfindung sieht die Versorgungsgrundvorrichtung beziehungsweise das Gehäusegrundmodul der Versorgungsgrundvorrichtung die Aufnahme für den Schließzylinder vor. Vorteilhaft kann es hierdurch gelingen, das Gehäuseverschlussmodul mit einer sehr grundlegenden, einfachen Geometrie auszustatten. Beispielsweise kann das Gehäuseverschlussmodul mit der Durchgangsausnehmung als Deckel, Klappe oder Tür realisiert sein und abnehmbar und/oder schwenkbar an der Versorgungsgrundvorrichtung beziehungsweise dem Gehäusegrundmodul gehalten sein.

Beispielsweise kann in der Schließstellung das Gehäuseverschlussmodul abschnittsweise in das Gehäusegrundmodul eingreifen. Insbesondere kann eine die Durchgangsausnehmung ausweisende Lasche des Gehäuseverschlussmoduls in das Gehäusegrundmodul eingreifen und benachbart zu der an dem Gehäusegrundmodul gebildeten Aufnahme vorgesehen sein. Beispielsweise kann vorgesehen sein, dass das Gehäuseverschlussmodul in der Schließstellung das Gehäusegrundmodul wenigstens abschnittsweise von außen umgreift und/oder dass die an dem Gehäuseverschlussmodul vorgesehene Durchgangsausnehmung dem Gehäusegrundmodul von außen zugeordnet ist.

Nach einer alternativen Weiterbildung der Erfindung ist die Aufnahme an dem Gehäuseverschlussmodul vorgesehen und die Durchgangsausnehmung an dem Gehäusegrundmodul gebildet.

Nach einer Weiterbildung der Erfindung ist in der Schließstellung des Gehäuseverschlussmoduls die Aufnahme für den Schließzylinder der an dem Gehäuseverschlussmodul gebildeten Durchgangsausnehmung derart zugeordnet, dass bei der Montage des Schließzylinders der Schließzylinderkörper abschnittsweise durch die Durchgangsausnehmung hindurchgeführt und in die Aufnahme eingesetzt ist. Vorteilhaft vereinfacht sich die Montage des Schließzylinders durch die entsprechende Zuordnung der Durchgangsausnehmung zu der Aufnahme. Die Schließstellung des Gehäuseverschlussmoduls bildet insofern die Ausgangsstellung für die Montage des Schließzylinders und die Blockade beziehungsweise Arretierung des Gehäuseverschlussmoduls erfolgt formschlüssig durch den Schließzylinderkörper des Schließzylinders.

Nach einer Weiterbildung der Erfindung liegt der Schließzylinderkörper in der Montageposition stirnseitig mit einer Anlagefläche desselben an einer als Anschlag und Positionierhilfe für den Schließzylinder dienenden Wandung des Gehäusegrundmoduls an. Vorteilhaft vereinfacht sich die Montage des Schließzylinders durch das Vorsehen der Wandung. Sie gibt eine definierte Montagetiefe für den Schließzylinder vor. Liegt der Schließzylinderkörper mit seiner Anlagefläche an der Wandung an, ist die Montageposition erreicht und das Verriegelungselement kann zum Arretieren beziehungsweise Festlegen des Gehäuseverschlussmoduls relativ zu dem Gehäusegrundmodul aus der Freigabestellung in die Verriegelungsstellung verbracht werden.

Nach einer Weiterbildung der Erfindung sieht die Aufnahme eine Anlagefläche vor, welche an eine Mantelgeometrie des Schließzylinderkörpers angepasst ist. Der Schließzylinderkörper liegt dann in der Montageposition mantelseitig mit seiner Mantelfläche an der Anlagefläche der Aufnahme an. Vorteilhaft vereinfacht sich durch die korrespondierende Gestaltung der Anlagefläche der Aufnahme einerseits und der Mantelfläche des Schließzylinderkörpers andererseits die Montage des Schließzylinders. Die Anlagefläche der Aufnahme dient insofern als Stütz- und Positionierfläche für den Schließzylinder.

Nach einer Weiterbildung der Erfindung sieht die Aufnahme zwei Halbschalen vor, welche bevorzugt je einen Teil der Anlagefläche der Aufnahme für den Schließzylinder bereitstellen. Beispielsweise ist eine erste Halbschale der Aufnahme an einem Trägerkörper des Gehäusegrundmoduls gebildet und/oder eine zweite Halbschale durch einen bügelförmigen Aufnahmekörper bereitgestellt, welcher lösbar mit dem Trägerkörper verbunden ist zur Bildung der Aufnahme. Vorteilhaft kann durch das Vorsehen der zwei Halbschalen die Fertigung des Gehäusegrundmoduls vereinfacht werden. Das Gehäusegrundmodul kann insofern aus dem Trägerkörper mit der ersten Halbschale und dem die zweite Halbschale bereitstellenden bügelförmigen Aufnahmekörper bestehen oder diese vorsehen. Insbesondere bei der Fertigung des Trägerkörpers als Kunststoffspritzgießteil werden hierdurch Hinterschneidungen vermieden, welche die Verwendung eines aufwendig geformten, mehrteiligen Werkzeugs und/oder eines Werkzeugs mit Kernen bedingen würde.

Nach einer Weiterbildung der Erfindung hintergreift das Verriegelungselement in der Verriegelungsstellung eine an der Versorgungsgrundvorrichtung und bevorzugt an dem Gehäusegrundmodul gebildete Rastkörperkante. Besonders bevorzugt hintergreift das Verriegelungselement in der Verriegelungsstellung den bügelförmigen Aufnahmekörper der Aufnahme, der insofern die Rastkörperkante bereitstellt, oder eine an dem Trägerkörper gebildete Rastkörperkante. Vorteilhaft kommt der Aufnahme hierdurch eine Doppelfunktion zu. Sie dient der Aufnahme und Positionierung des Schließzylinders einerseits und als Wirkpartner des Verriegelungselements andererseits.

Beispielsweise kann das Verriegelungselement in der Verriegelungsstellung in eine an der Versorgungsgrundvorrichtung beziehungsweise dem Gehäusegrundmodul oder dem Gehäuseverschlussmodul gebildete Rastausnehmung eingreifen. Die Rastausnehmung kann beispielsweise taschenförmig ausgebildet sein und/oder die Rastkörperkante für das Verriegelungselement bereitstellen.

Nach einer Weiterbildung der Erfindung ist ein Schlüsselspalt des Schließzylinders in der Montageposition zugänglich außerhalb der Aufnahme und/oder an einer der stirnseitigen Anlagefläche des Schließzylinderkörpers gegenüberliegenden Stirnseite des Schließzylinders vorgesehen. Vorteilhaft ist hierdurch gewährleistet, dass das Ansetzen des Schlüssels in einfacher Weise möglich ist.

Nach einer Weiterbildung der Erfindung ist der Schlüsselspalt in der Montageposition an einer dem Boden zugewandten Unterseite der Versorgungsstation vorgesehen. Vorteilhaft wird hierdurch dem Eindringen von Schmutz beziehungsweise Feuchtigkeit entgegengewirkt. Darüber hinaus sind der Schließzylinder und der Schlüsselspalt verdeckt beziehungsweise geschützt angeordnet mit der Folge, dass die Versorgungsstation eine insgesamt ansprechende Erscheinung erhält und/oder einer Manipulation beziehungsweise einem Missbrauch entgegengewirkt ist.

Zur Lösung der Aufgabe weist die Erfindung die Merkmale des Patentanspruchs 13 auf. Demzufolge umfasst eine Versorgungsfunktionsgrundanordnung für eine erfindungsgemäße Versorgungsstation die Versorgungsgrundvorrichtung mit dem Gehäusegrundmodul und mit der Mehrzahl der daran installierten Schalt- und/oder Sicherungskomponenten. Ferner umfasst die Versorgungsfunktionsgrundanordnung das Gehäuseverschlussmodul mit der Durchgangsausnehmung sowie die Aufnahme für den Schließzylinder. Die Versorgungsfunktionsgrundanordnung stellt demzufolge den Lieferumfang eines Herstellers einer Versorgungsstation dar. Die Versorgungsfunktionsgrundanordnung wird betreiberseitig durch die Beistellung eines Schließzylinders zu der Versorgungsstation ergänzt oder vervollständigt.

Aus den weiteren Unteransprüchen und der nachfolgenden Beschreibung sind weitere Vorteile, Merkmale und Einzelheiten der Erfindung zu entnehmen. Dort erwähnte Merkmale können jeweils einzeln für sich oder auch in beliebiger Kombination erfindungswesentlich sein. So kann auf die Offenbarung zu den einzelnen Erfindungsaspekten stets wechselseitig Bezug genommen werden. Die Zeichnungen dienen lediglich beispielhaft der Klarstellung der Erfindung. Sie haben keinen einschränkenden Charakter.

Es zeigen:
- Fig. 1: eine Frontseitenansicht eines Gehäuseverschlussmoduls einer Versorgungsstation,
- Fig. 2: eine Unterseitenansicht des Versorgungsstation mit dem Gehäusegrundmodul, dem Gehäuseverschlussmodul und einem Schließzylinder als Schließeinheit in einer Montageposition,
- Fig. 3: eine Unterseitenansicht des Gehäuseverschlussmoduls mit einer Durchgangsausnehmung,
- Fig. 4: einen Querschnitt durch das Gehäuseverschlussmodul und einen Trägerkörper des Gehäusegrundmoduls,
- Fig. 5: die Querschnittdarstellung nach Fig. 4 mit dem Gehäuseverschlussmodul, dem Trägerkörper und einem hieran lösbar gehaltenen Aufnahmekörper des Gehäusegrundmoduls,
- Fig. 6: die Querschnittdarstellung nach Fig. 5 mit dem in eine an dem Gehäusegrundmodul gebildeten Aufnahme eingesetzten Schließzylinder in einer Verriegelungsstellung,
- Fig. 7: einen Teillängsschnitt durch die Versorgungsstation nach Fig. 2 mit dem Schließzylinder in der Montageposition und
- Fig. 8: eine alternative Ausführungsform des Gehäuseverschlussmoduls.

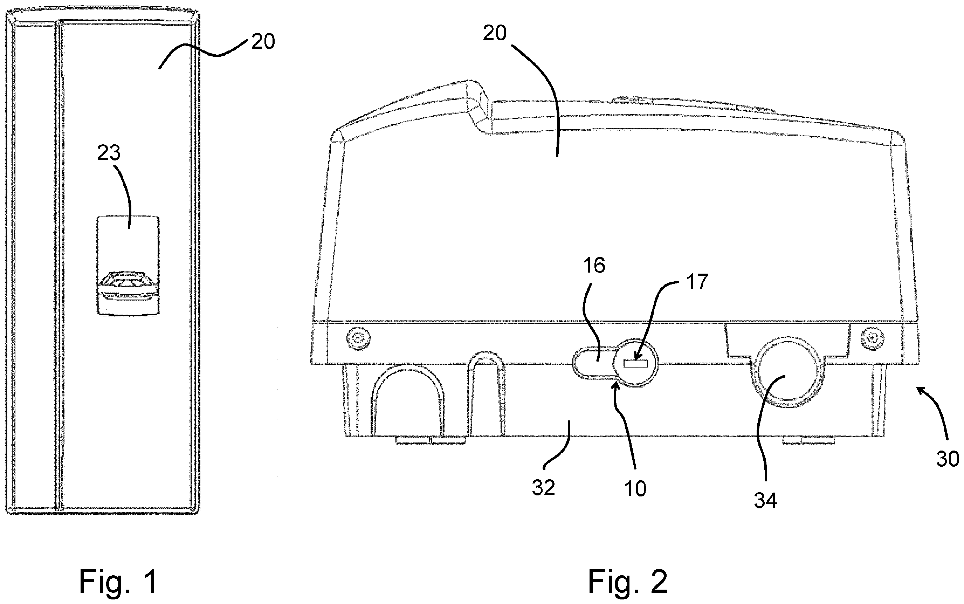

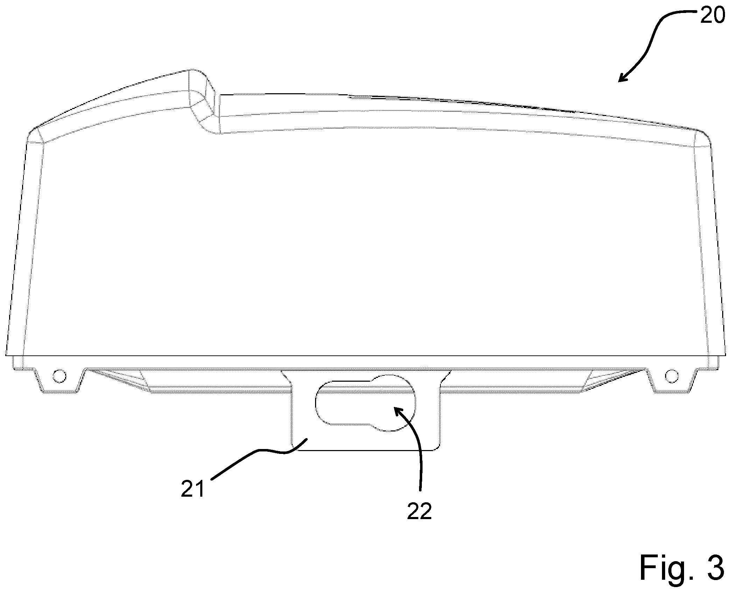

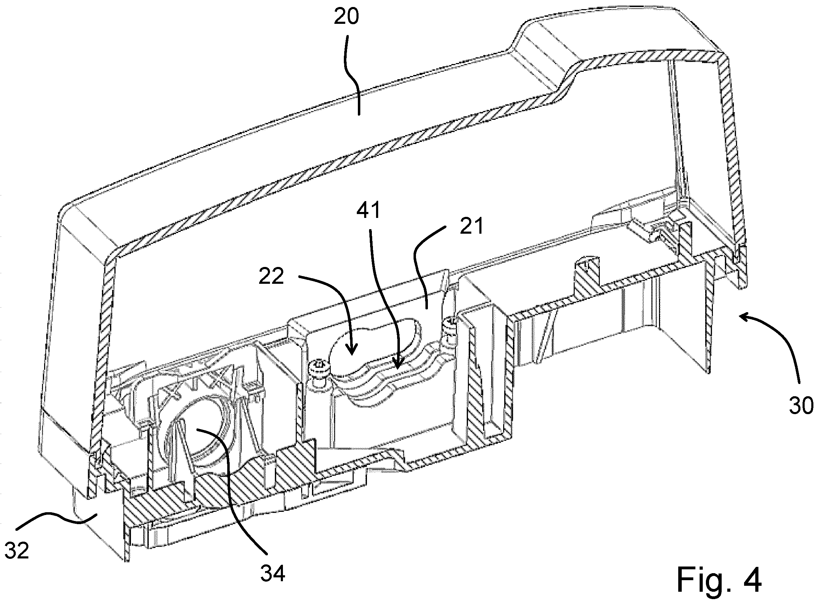

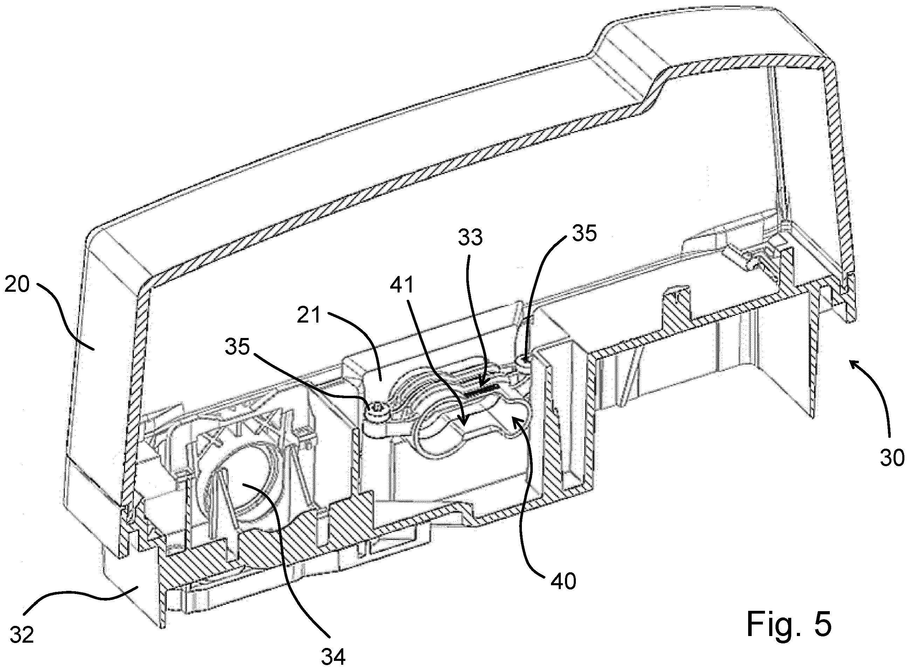

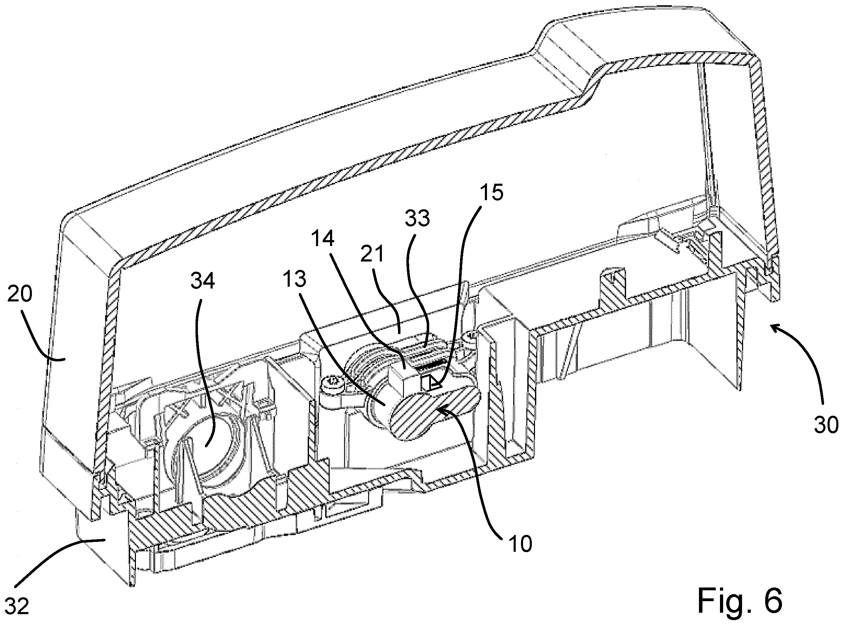

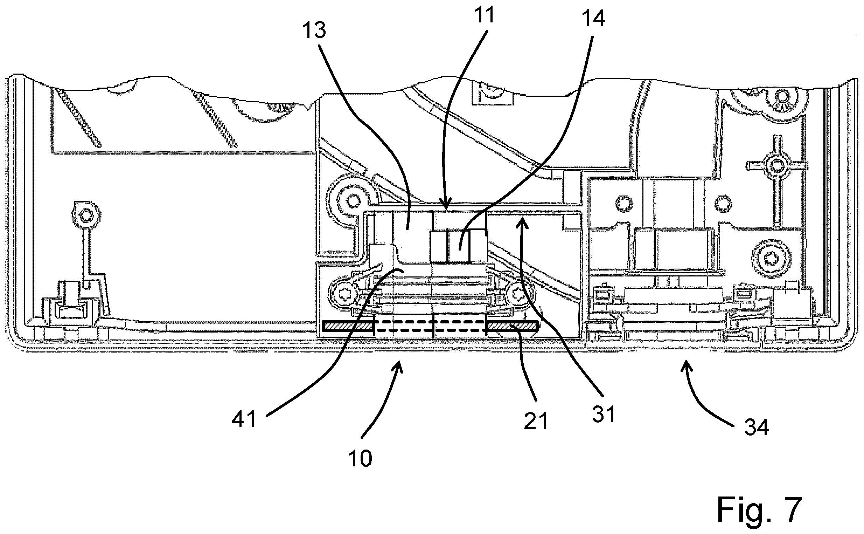

Eine Versorgungsstation nach den Figuren 1 bis 7 sieht ein mehrteiliges Vorrichtungsgehäuse mit einem Gehäusegrundmodul 30 als einer ersten Gehäusekomponente und mit einem Gehäuseverschlussmodul 20 als einer zweiten Gehäusekomponente vor. Das Gehäuseverschlussmodul 20 ist nach Art einer Klappe beziehungsweise eines Deckels ausgebildet und an das Gehäusegrundmodul 30 ansetzbar. In einer Öffnungsstellung des Gehäuseverschlussmoduls 20 sind Schalt- und/oder Sicherheitskomponenten der Versorgungsstation, die an dem Gehäusegrundmodul 30 installiert sind, zugänglich, wohingegen diese in einer Schließstellung des Gehäuseverschlussmoduls 20 unzugänglich in dem Vorrichtungsgehäuse angeordnet sind.

Zum Festlegen beziehungsweise Arretieren des Gehäuseverschlussmoduls 20 in der Schließstellung relativ zu dem Gehäusegrundmodul 30 sieht die Versorgungsstation einen Schließzylinder 10 als Schließeinheit vor. Der Schließzylinder 10, welcher vorliegend als ein Halbzylinder ausgebildet ist, umfasst einen Schließzylinderkörper 13 sowie ein betätigbares Verriegelungselement 14, welches über einen nicht dargestellten Schlüssel von einer Verriegelungsstellung in eine Freigabestellung und zurück verbringbar ist. An dem Schließzylinderkörper 13 ist eine Riegelausnehmung 15 vorgesehen, in der das Verriegelungselement 14 in der Freigabestellung vorgesehen ist.

Das Gehäusegrundmodul 30 bildet mit den daran installierten Schalt- und Sicherheitskomponenten eine Versorgungsgrundvorrichtung der Versorgungsstation. Die Versorgungsgrundvorrichtung stellt die für einen Ladevorgang funktionsnotwendigen Komponenten der Versorgungsstation bereit. Insbesondere umfasst die Versorgungsgrundvorrichtung ein nicht dargestelltes Steckelement, welches dem Anschluss eines elektrisch betreibbaren Fahrzeugs an die Versorgungsstation dient, eine Steuereinheit, ein Schütz als Schaltkomponente sowie einen Fehlerstromschutzschalter und/oder diverse Leitungssicherungen als Sicherheitskomponenten. Zudem können ein Energiemengenzähler sowie eine Kommunikationsschnittstelle für den Nutzer vorgesehen sein.

Neben der Versorgungsgrundvorrichtung sind das Gehäuseverschlussmodul 20 sowie der Schließzylinder 10 wesentliche Komponenten der Versorgungsstation. An dem Gehäuseverschlussmodul 20 ist ein Schiebedeckel 23 ausgebildet. Der Schiebedeckel 23 ist in der Schließstellung dem Steckelement zugeordnet. Er kann wahlweise geöffnet oder geschlossen werden zur Freigabe oder Überdeckung des Steckelements.

Zur Festlegung des Gehäuseverschlussmoduls 20 an dem Gehäusegrundmodul 30 wird das Gehäuseverschlussmodul 20 in der Schließstellung vorgesehen. In der Schließstellung ist eine an dem Gehäuseverschlussmodul 20 gebildete Durchgangsausnehmung 22 einer an dem Gehäusegrundmodul 30 gebildeten Aufnahme 40 so zugeordnet, dass der Schließzylinder 10 durch die Durchgangsausnehmung 22 hindurch in die Aufnahme 40 eingesetzt werden kann. Eine Montageposition ist erreicht, sobald der Schließzylinder 10 mit einer stirnseitig vorgesehenen Anlagefläche 11 des Schließzylinderkörpers 13 an einer Wandung 31 des Gehäusegrundmoduls 30 angelegt ist. In der Montageposition liegt eine durch den Schließzylinderkörper 13 des Schließzylinders 10 bereitgestellte Mantelfläche 12 des Schließzylinders 10 abschnittsweise an einer Anlagefläche 41 der Aufnahme 40 an. Die Wandung 31 des Gehäusegrundmoduls 30 sowie die Anlagefläche 41 der Aufnahme 40 dienen insofern als ein Anschlag und eine Positionierhilfe bei der Montage des Schließzylinders 10.

Die Anlagefläche 41 der Aufnahme 40 ist im vorliegenden Ausführungsbeispiel der Erfindung geteilt realisiert. Ein erster Teil der Anlagefläche 41 ist an einem Trägerkörper 32 des Gehäusegrundmoduls 30 nach Art einer Halbschale gebildet. An dem Trägerkörper 32 kann über Schrauben 35 ein Aufnahmekörper 33 festgelegt werden, der einen zweiten Teil der Anlagefläche 41 bereitstellt und ebenfalls abschnittsweise halbschalenförmig ausgebildet ist.

Durch die mehrteilige Ausbildung der Aufnahme 40 gelingt es, sowohl den Trägerkörper 32 als auch den Aufnahmekörper 33 des Gehäusegrundmoduls 30 fertigungsgerecht zu konstruieren. Hinterschneidungen, welche beim Kunststoffspritzgießen eine aufwendige Konstruktion des Werkzeugs erfordern, können durch die zweiteilige Gestaltung der Aufnahme 40 vermieden werden.

Der Trägerkörper 32 des Gehäusegrundmoduls 30 dient neben der Bereitstellung eines Teils der Anlagefläche 41 der Installation der Schalt- und Sicherheitskomponenten und der Befestigung der Versorgungsgrundvorrichung an einer Wand oder einer sonstigen Tragkomponente. Hierzu können an dem Trägerkörper 32 der Aufnahme von Befestigungsmitteln dienende Befestigungsausnehmungen vorsehen.

Der Trägerkörper 32 sieht eine Zuleitungsöffnung 34 für eine elektrische Zuleitung vor. Die Zuleitungsöffnung 34 ist benachbart zu der Aufnahme 40 an einer Unterseite des Trägerkörpers 32 angeordnet.

In der Montageposition ist der Halbzylinder 10 so in die Aufnahme 40 eingesetzt, dass der Schließzylinderkörper 13 zugleich in der Aufnahme 40 vorgesehen ist und durch die Durchgangsausnehmung 22 hindurchragt. Der Schließzylinderkörper 13 legt also das Gehäuseverschlussmodul 20 relativ zum Gehäusegrundmodul 30 fest und verhindert, dass das Gehäuseverschlussmodul 20 aus der Schließstellung in die Öffnungsstellung verbracht werden kann. Die Arretierung des Gehäuseverschlussmoduls 20 relativ zu und an dem Gehäusegrundmodul 30 erfolgt demzufolge formschlüssig über den Schließzylinderkörper 13 des Schließzylinders 10.

Eine Sicherung des Schließzylinders 10 gegen eine Entnahme aus der Aufnahme 40 erfolgt in der Montageposition mithilfe des Verriegelungselements 14 des Schließzylinders 10. Während das Verriegelungselement 14 während der Montage des Schließzylinders 10 in der Freigabestellung vorgesehen ist und in die Riegelausnehmung 15 eingreift, kann das Verriegelungselement 14 in der Montageposition aus der Freigabestellung in die Verriegelungsstellung verbracht werden. In der Verriegelungsstellung hintergreift das Verriegelungselement 14 den Aufnahmekörper 33, sodass der Schließzylinder 10 nicht mehr aus der Ausnahme 40 entnommen werden kann. Eine weitergehende Befestigung des Schließzylinders 10 beziehungsweise des Schließzylinderkörpers 13 an dem Gehäusegrundmodul 30 oder einer anderen Funktionskomponente der Versorgungsgrundvorrichtung erfolgt nicht. Der Schließzylinder 10 ist insofern als loses Bauteil beziehungsweise fliegender Schließzylinder 10 realisiert.

Die Montage des Schließzylinders 10 erfolgt werkzeuglos. Zum Festlegen des Gehäuseverschlussmoduls 20 in der Schließstellung ist ebenfalls kein Werkzeug erforderlich. Die Festlegung erfolgt allein über den Schließzylinder 10 mithilfe des nicht dargestellten Schlüssels. Ein Schlüsselspalt 17 des Schließzylinders 10 ist an einer der Anlagefläche 11 gegenüberliegenden Stirnseite 16 vorgesehen und außerhalb des Gehäusegrundmoduls 30 beziehungsweise des Gehäuseverschlussmoduls 20 mit der Durchgangsausnehmung 22 vorgesehen. Die Durchgangsausnehmung 22 ist an einer Lasche 21 des Gehäuseverschlussmoduls 20 gebildet. Die Lasche 21 greift in der Schließstellung des Gehäuseverschlussmoduls 20 in das Gehäusegrundmodul 30 ein.

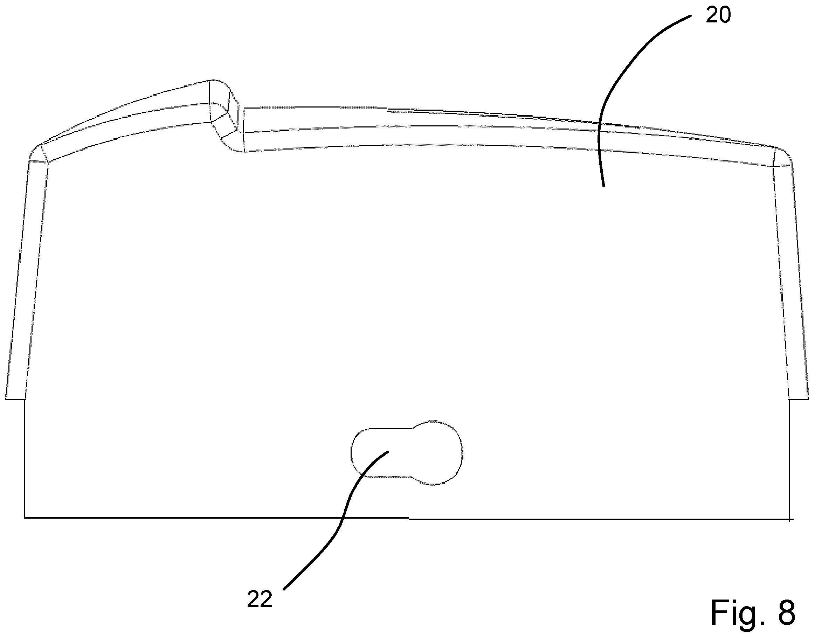

Figur 8 zeigt eine alternative Ausführungsform des Gehäuseverschlussmoduls 20. Hier ist auf die Lasche 21 verzichtet. Stattdessen ist die Durchgangsausnehmung 22 unmittelbar in einer unteren Seitenwand des Gehäuseverschlussmoduls 20 vorgesehen. Das Gehäuseverschlussmodul 20 umgreift in der Schließstellung das Gehäusegrundmodul 30 der Versorgungsgrundvorrichtung von außen.

Gleiche Bauteile und Bauteilfunktionen sind durch gleiche Bezugszeichen gekennzeichnet.

Während die Versorgungsstation neben der Versorgungsgrundvorrichtung das Gehäuseverschlussmodul 20 sowie den fliegenden Schließzylinder 10 vorsieht, umfasst eine Versorgungsfunktionsgrundanordnung lediglich die Versorgungsgrundvorrichtung mit dem Gehäusegrundmodul 30 und der Mehrzahl der daran installierten Schalt- und/oder Sicherungskomponenten sowie das Gehäuseverschlussmodul 20 mit der Durchgangsausnehmung 30 und die Aufnahme 40. Der Schließzylinder 10 ist nicht Teil der Versorgungsfunktionsgrundanordnung.

Beispielsweise kann die Versorgungsfunktionsgrundanordnung den Lieferumfang eines Herstellers von Versorgungsstationen bilden. Der Schließzylinder 10 kann kundenbeziehungsweise betreiberseitig beigestellt werden zur Vervollständigung der Funktionsstation. Es werden hier insbesondere handelsübliche, genormte Schließzylinder beziehungsweise Profilzylinder und bevorzugt Halbzylinder verwendet, die eine genormte, stets gleiche Anschluss- beziehungsweise Außengeometrie aufweisen und insofern einfach installiert und ausgetauscht werden können.

## Patentansprüche

1. Versorgungsstation zum Bereitstellen elektrischer Energie für ein elektrisch betreibbares Fahrzeug umfassend
- eine Versorgungsgrundvorrichtung mit einem Gehäusegrundmodul (30) als einer ersten Gehäusekomponente eines Vorrichtungsgehäuses und mit einer Mehrzahl von daran installierten Schalt- und/oder Sicherheitskomponenten,
- ein Gehäuseverschlussmodul (20) als einer zweiten Gehäusekomponente des Vorrichtungsgehäuses, wobei das Gehäuseverschlussmodul (20) an das Gehäusegrundmodul (30) ansetzbar ist und wobei die Schalt- und/oder Sicherheitskomponenten in einer Öffnungsstellung des Gehäuseverschlussmoduls (20) zugänglich sind und in einer Schließstellung des Gehäuseverschlussmoduls (20) unzugänglich in dem Vorrichtungsgehäuse angeordnet sind,
- sowie eine dem Vorrichtungsgehäuse zugeordnete Schließeinheit mit einem betätigbaren Verriegelungselement (14), welches von einer Verriegelungsstellung in eine Freigabestellung und zurück verbringbar ist,
**dadurch gekennzeichnet, dass** ein Schließzylinder (10) mit einem Schließzylinderkörper (13) und dem relativ-beweglich zu dem Schließzylinderkörper (13) an ebendiesem gehaltenen Verriegelungselement (14) als Schließeinheit dient, wobei der Schließzylinder (10) als ein loses Bauteil der Versorgungsstation ausgebildet ist, welches weder mit der Versorgungsgrundvorrichtung noch mit dem Gehäuseverschlussmodul (20) des Vorrichtungsgehäuses dauerhaft verbunden ist, und dass zur Festlegung des Gehäuseverschlussmoduls (20) relativ zu dem Gehäusegrundmodul (30) an dem Vorrichtungsgehäuse eine Aufnahme (40) für den Schließzylinder (10) vorgesehen ist, in die der Schließzylinder (10) in der Schließstellung des Gehäuseverschlussmoduls (20) montierbar ist, wobei der Schließzylinder (10) in seiner Montageposition und in der Schließstellung des Gehäuseverschlussmoduls (20) in eine an der ersten oder der zweiten Gehäusekomponente des Vorrichtungsgehäuses gebildete Durchgangsausnehmung (22) eingreift und in die an der jeweils anderen Gehäusekomponente der Versorgungsstation gebildete Aufnahme (40) eingesetzt ist und so eine Verbringung des Gehäuseverschlussmoduls (20) in die Öffnungsstellung blockiert ist und wobei das Verriegelungselement (14) des in der Aufnahme (40) eingesetzten Schließzylinders (10) aus der Freigabestellung in die Verriegelungsstellung verbringbar ist zur Sicherung der Schließzylinders (10) gegen eine Entnahme desselben aus der Aufnahme (40).

2. Versorgungsstation nach Anspruch 1, **dadurch gekennzeichnet, dass** die Versorgungsgrundvorrichtung und bevorzugt das Gehäusegrundmodul (30) der Versorgungsgrundvorrichtung die Aufnahme (40) für den Schließzylinderkörper (13) vorsieht und/oder dass das Gehäuseverschlussmodul (20) die Durchgangsausnehmung (22) vorsieht.

3. Versorgungsstation nach Anspruch 1 oder 2, **dadurch gekennzeichnet, dass** in der Schließstellung des Gehäuseverschlussmoduls (20) die Aufnahme (40) für den Schließzylinderkörper (13) der Durchgangsausnehmung (22) derart zugeordnet ist, dass bei der Montage des Schließzylinders (10) ebendieser abschnittsweise durch die Durchgangsausnehmung (22) hindurchgeführt und in die Aufnahme (40) eingesetzt wird.

4. Versorgungsstation nach einem der Ansprüche 1 bis 3, **dadurch gekennzeichnet, dass** der Schließzylinder (10) als ein Halbzylinder ausgebildet ist.

5. Versorgungsstation nach einem der Ansprüche 1 bis 4, **dadurch gekennzeichnet, dass** der Schließzylinderkörper (13) des Schließzylinders (10) in der Montageposition stirnseitig mit einer Anlagefläche (11) an einer als Anschlag und Positionierhilfe für den Schließzylinder (10) dienenden Wandung (31) des Gehäusegrundmoduls (30) angelegt ist.

6. Versorgungsstation nach einem der Ansprüche 1 bis 5, **dadurch gekennzeichnet, dass** die Aufnahme (40) eine an eine Mantelgeometrie des Schließzylinderkörpers (13) angepasste Anlagefläche (41) vorsieht und dass der Schließzylinderkörper (13) in der Montageposition mantelseitig mit einer Mantelfläche (12) an der Anlagefläche (41) der Aufnahme (40) angelegt ist.

7. Versorgungsstation nach einem der Ansprüche 1 bis 6, **dadurch gekennzeichnet, dass** die Aufnahme (40) zwei Halbschalen vorsieht, welche bevorzugt je einen Teil der Anlagefläche (41) für den Schließzylinderkörper (13) bereitstellen.

8. Versorgungsstation nach Anspruch 7, **dadurch gekennzeichnet, dass** eine erste Halbschale der Aufnahme (40) an einem Trägerkörper (32) des Gehäusegrundmoduls (30) gebildet ist und/oder dass eine zweite Halbschale durch einen bügelförmigen Aufnahmekörper (33) bereitgestellt ist, wobei der Aufnahmekörper (33) bevorzugt lösbar mit dem Trägerkörper (32) verbunden ist zur Bildung der Aufnahme (40).

9. Versorgungsstation nach Anspruch 8, **dadurch gekennzeichnet, dass** das Verriegelungselement (14) den Aufnahmekörper (33) in der Verriegelungsstellung hintergreift und/oder dass das Verriegelungselement (14) in der Verriegelungsstellung zwischen dem Aufnahmekörper (33) des Gehäusegrundmoduls (30) einerseits und der Wandung (31) des Gehäusegrundmoduls (30) anderseits positioniert ist.

10. Versorgungsstation nach einem der Ansprüche 1 bis 9, **dadurch gekennzeichnet, dass** ein Schlüsselspalt (17) des Schließzylinders (10) in der Montageposition zugänglich außerhalb der Aufnahme (40) und/oder an einer der stirnseitigen Anlagefläche (11) gegenüberliegenden Stirnseite (16) des Schließzylinders (10) vorgesehen ist.

11. Versorgungsstation nach einem der Ansprüche 1 bis 10, **dadurch gekennzeichnet, dass** an dem Schließzylinderkörper (13) eine taschenförmige Riegelausnehmung (15) vorgesehen ist, in die das Verriegelungselement (14) in der Freigabestellung eingreift.

12. Versorgungsstation nach einem der Ansprüche 1 bis 11, **dadurch gekennzeichnet, dass** das Gehäusegrundmodul (30) und/oder der Trägerkörper (32) der Aufnahme von Befestigungsmitteln dienende Befestigungsausnehmungen vorsehen zur Wandmontage der Versorgungsgrundvorrichtung.

13. Versorgungsfunktionsgrundanordnung für eine Versorgungsstation nach einem der Ansprüche 1 bis 12 umfassend die Versorgungsgrundvorrichtung mit dem Gehäusegrundmodul (30) und mit der Mehrzahl von daran installierten Schalt- und/oder Sicherheitskomponenten, umfassend das Gehäuseverschlussmodul (20) mit der Durchgangsausnehmung (22) und umfassend die Aufnahme (40) für den nicht Teil der Versorgungsfunktionsgrundanordnung ausmachenden Schließzylinder (10).

14. Verwendung eines Halbzylinders als Schließzylinder (10) für eine Versorgungsstation nach einem der Ansprüche 1 bis 12 und/oder für eine Versorgungsfunktionsgrundanordnung nach Anspruch 13.

## Claims

1. Supply station for providing electrical energy for an electrically operable vehicle comprising
- a supply base apparatus having a housing base module (30) as a first housing component of an apparatus housing and having a plurality of switching and/or safety components that are installed thereon,
- a housing closure module (20) as a second housing component of the apparatus housing, wherein the housing closure module (20) can be placed on the housing base module (30) and wherein the switching and/or safety components are arranged in the apparatus housing in an accessible manner in an opened position of the housing closure module (20) and in an inaccessible manner in a closed position of the housing closure module (20),
- and also a closure unit, which is allocated to the apparatus housing, having an actuatable locking element (14) that can be brought from a locked position into a release position and back,
**characterised in that** a closure cylinder (10) having a closure cylinder body (13) and the locking element (14) that is held on the locking cylinder (13) so as to be movable relative thereto is used as a closure unit, wherein the closure cylinder (10) is embodied as a loose component of the supply station, which is neither permanently connected to the supply base apparatus nor permanently connected to the housing closure module (20) of the apparatus housing, and that in order to fix the housing closure module (20) relative to the housing base module (30) on the apparatus housing a receiving arrangement (40) is provided for the closure cylinder (10) and the closure cylinder (10) can be mounted in the receiving arrangement in the closed position of the housing closure module (20), wherein the closure cylinder (10) in its mounted position and in the closed position of the housing closure module (20) engages into a passage recess (22) that is formed on the first or the second housing component of the apparatus housing and is inserted into the receiving arrangement (40) that is formed on the respective other housing component of the supply station and thus a movement of the housing closure module (20) into the opened position is blocked and wherein the locking element (14) of the closure cylinder (10) that is inserted into the receiving arrangement (40) can be brought out of the release position into the locked position in order to secure the closure cylinder (10) against removal of the closure cylinder from the receiving arrangement (40).

2. Supply station according to claim 1, **characterised in that** the supply base apparatus and preferably the housing base module (30) of the supply base apparatus provides the receiving arrangement (40) for the closure cylinder body (13) and/or that the housing closure module (20) provides the passage recess (22).

3. Supply station according to claim 1 or 2, **characterised in that** in the closed position of the housing closure module (20) the receiving arrangement (40) for the closure cylinder body (13) is allocated to the passage recess (22) in such a manner that as the closure cylinder (10) is being mounted it is guided in sections through the passage recess (22) and is inserted into the receiving arrangement (40).

4. Supply station according to one of claims 1 to 3, **characterised in that** the closure cylinder (10) is embodied as a half cylinder.

5. Supply station according to one of claims 1 to 4, **characterised in that** the closure cylinder body (13) of the closure cylinder (10) in the mounted position is placed on the end face with a contact surface (11) on a wall (31) of the housing base module (30), said wall being used as a stop and positioning aid for the closure cylinder (10).

6. Supply station according to one of claims 1 to 5, **characterised in that** the receiving arrangement (40) provides a contact surface (41) that is adapted to a shell geometry of the closure cylinder body (13) and that the closure cylinder body (13) in the mounted position is placed on the shell side with a shell surface (12) against the contact surface (41) of the receiving arrangement (40).

7. Supply station according to one of claims 1 to 6, **characterised in that** the receiving arrangement (40) provides two half shells that preferably each provide a part of the contact surface (41) for the closure cylinder body (13).

8. Supply station according to claim 7, **characterised in that** a first half shell of the receiving arrangement (40) is formed on a carrier body (32) of the housing base module (30) and/or that a second half shell is provided by means of a bow-shaped receiving body (33), wherein the receiving body (33) is preferably connected to the carrier body (32) in a detachable manner in order to form the receiving arrangement (40).

9. Supply station according to claim 8, **characterised in that** the locking element (14) engages behind the receiving body (33) in the locked position and/or that the locking element (14) in the locked position is positioned between the receiving body (33) of the housing base module (30) on the one hand and the wall (31) of the housing base module (30) on the other hand.

10. Supply station according to one of claims 1 to 9, **characterised in that** a key column (17) of the closure cylinder (10) in the mounted position is provided in an accessible manner outside the receiving arrangement (40) and/or on an end face (16) of the closure cylinder (10) that lies opposite the end face contact surface (11).

11. Supply station according to one of claims 1 to 10, **characterised in that** a pocket-shaped latch recess (15) is provided on the closure cylinder body (13) and the locking element (14) engages into the latch recess in the release position.

12. Supply station according to one of claims 1 to 11, **characterised in that** the housing base module (30) and/or the carrier body (32) of the receiving arrangement provide fastening recesses that serve as fastening means for wall mounting the supply base apparatus.

13. Supply function base arrangement for a supply station according to one of claims 1 to 12 comprising the supply base apparatus having the housing base module (30) and having the plurality of switching and/or safety components that are installed thereon, comprising the housing closure module (20) having the passage recess (22) and comprising the receiving arrangement (40) for the closure cylinder (10) that does not amount to part of the supply function base arrangement.

14. Use of a half cylinder as a closure cylinder (10) for a supply station according to one of claims 1 to 12 and/or for a supply function base arrangement according to claim 13.

## Revendications

1. Station d'approvisionnement destinée à fournir de l'énergie électrique pour un véhicule électrique, comprenant :
- un dispositif d'approvisionnement de base comportant un module de boîtier de base (30) en tant que premier composant de boîtier d'un boîtier de dispositif et comportant une pluralité de composants de commutation et/ou de sécurité installés sur celui-ci,
- un module de couvercle de boîtier (20) en tant que second composant de boîtier du boîtier de dispositif, dans laquelle le module de couvercle de boîtier (20) peut être placé sur le module de boîtier de base (30) et dans laquelle les composants de commutation et/ou de sécurité sont accessibles dans une position d'ouverture du module de couvercle de boîtier (20) et sont agencés dans le boîtier de dispositif de manière inaccessible dans une position de fermeture du module de couvercle de boîtier (20),
- ainsi qu'une unité de fermeture associée au boîtier de dispositif avec un élément de verrouillage actionnable (14), qui peut être amené d'une position de verrouillage à une position de libération et vice versa,
**caractérisée en ce qu'**un barillet de fermeture (10) ayant un corps de barillet de fermeture (13) et l'élément de verrouillage (14) mobile de manière relative par rapport au corps de barillet de fermeture (13) et maintenu sur celui-ci sert d'unité de fermeture, dans laquelle le barillet de fermeture (10) est conçu comme un composant non fixé de la station d'approvisionnement, qui est en permanence relié soit au dispositif d'approvisionnement de base, soit au module de couvercle de boîtier (20) du boîtier de dispositif, et **en ce qu'**un logement (40) pour le barillet de fermeture (10) est prévu sur le boîtier de dispositif pour fixer le module de couvercle de boîtier (20) par rapport au module de boîtier de base (30), logement dans lequel le barillet de fermeture (10) peut être monté dans la position de fermeture du module de couvercle de boîtier (20), dans laquelle le barillet de fermeture (10) dans sa position de montage et dans la position de fermeture du module de couvercle de boîtier (20) s'engage dans un évidement de passage (22) formé sur le premier ou le second composant de boîtier du boîtier de dispositif et est inséré dans le logement (40) respectivement formé sur l'autre composant de boîtier de la station d'approvisionnement, et un passage du module de couvercle de boîtier (20) est ainsi bloqué dans la position d'ouverture et dans laquelle l'élément de verrouillage (14) du barillet de fermeture (10) inséré dans le logement (40) peut être amené de la position de libération à la position de verrouillage pour bloquer le barillet de fermeture (10) en empêchant un retrait de celui-ci hors du logement (40).

2. Station d'approvisionnement selon la revendication 1, **caractérisée en ce que** le dispositif d'approvisionnement de base et, de préférence, le module de boîtier de base (30) du dispositif d'approvisionnement de base fournissent le logement (40) pour le corps de barillet de fermeture (13) et/ou **en ce que** le module de couvercle de boîtier (20) fournit l'évidement de passage (22).

3. Station d'approvisionnement selon la revendication 1 ou 2, **caractérisée en ce que** dans la position de fermeture du module de couvercle de boîtier (20), le logement (40) pour le corps de barillet de fermeture (13) est associé à l'évidement de passage (22), de telle sorte que lors du montage du barillet de fermeture (10), ce dernier est introduit au moins partiellement à travers l'évidement de passage (22) et est inséré dans le logement (40).

4. Station d'approvisionnement selon l'une des revendications 1 à 3, **caractérisée en ce que** le barillet de fermeture (10) est réalisé sous la forme d'un demi-barillet.

5. Station d'approvisionnement selon l'une des revendications 1 à 4, **caractérisée en ce que** le corps de barillet de fermeture (13) du barillet de fermeture (10) est posé dans la position de montage, côté avant, avec une surface de contact (12) sur une paroi (31) du module de boîtier de base (30) servant de butée et d'aide au positionnement pour le barillet de fermeture (10).

6. Station d'approvisionnement selon l'une des revendications 1 à 5, **caractérisée en ce que** le logement (40) fournit une surface de contact (41) adaptée à une géométrie d'enveloppe du corps de barillet de fermeture (13) et **en ce que** le corps de barillet de fermeture (13) est posé dans la position de montage, côté latéral, avec une surface latérale (12) sur la surface de contact (41) du logement (40).

7. Station d'approvisionnement selon l'une des revendications 1 à 6, **caractérisée en ce que** le logement (40) fournit deux demi-coques qui fournissent chacune, de préférence, une partie de la surface de contact (41) pour le corps de barillet de fermeture (13).

8. Station d'approvisionnement selon la revendication 7, **caractérisée en ce qu'**une première demi-coque du logement (40) est formée sur un corps de support (32) du module de boîtier de base (30) et/ou **en ce qu'**une seconde demi-coque est fournie par un corps d'évidement (33) en forme d'étrier, dans laquelle le corps d'évidement (33) est relié au corps de support (32) de préférence de manière amovible pour former le logement (40).

9. Station d'approvisionnement selon la revendication 8, **caractérisée en ce que** l'élément de verrouillage (14) vient en prise par l'arrière avec le corps d'évidement (33) dans la position de verrouillage et/ou **en ce que** l'élément de verrouillage (14) dans la position de verrouillage est positionné entre le corps d'évidement (33) du module de boîtier de base (30), d'une part, et la paroi (31) du module de boîtier de base (30), d'autre part.

10. Station d'approvisionnement selon l'une des revendications 1 à 9, **caractérisée en ce qu'**une fente de clé (17) du barillet de fermeture (10) est prévue dans la position de montage accessible depuis l'extérieur du logement (40) et/ou sur une face avant (16) du barillet de fermeture (10) opposée à la surface de contact (11) frontale.

11. Station d'approvisionnement selon l'une des revendications 1 à 10, **caractérisée en ce que** sur le corps de barillet de fermeture (13) est prévu un évidement de verrou (15) en forme de poche, évidement dans lequel l'élément de verrouillage (14) s'engage dans la position de libération.

12. Station d'approvisionnement selon l'une des revendications 1 à 11, **caractérisée en ce que** le module de boîtier de base (30) et/ou le corps de support (32) fournit des évidements de fixation servant à recevoir des moyens de fixation pour le montage mural du dispositif d'approvisionnement de base.

13. Système de base à fonction d'approvisionnement pour une station d'approvisionnement selon l'une des revendications 1 à 12, comprenant le dispositif d'approvisionnement de base avec le module de boîtier de base (30) et la pluralité de composants de commutation et/ou de sécurité installés sur celui-ci, comprenant le module de couvercle de boîtier (20) avec l'évidement de passage (22) et comprenant le logement (40) pour le barillet de fermeture (10) ne faisant pas partie du système de base à fonction d'approvisionnement.

14. Utilisation d'un demi-barillet en tant que barillet de fermeture (10) pour une station d'approvisionnement selon l'une des revendications 1 à 12 et/ou pour un système de base à fonction d'approvisionnement selon la revendication 13.
